# EUROPÄISCHE PATENTSCHRIFT

(11) **EP 0 538 280 B1**
(45) Veröffentlichungstag und Bekanntmachung des Hinweises auf die Patenterteilung: **17.08.1994**
(21) Anmeldenummer: 91911276.3
(22) Anmeldetag: 27.06.1991
(51) Int. Cl.: H01C 10/30, H05K 1/18

(54) **SCHALTERANORDNUNG MIT REGELBAREM WIDERSTAND**
RHEOSTATIC SWITCHING ARRANGEMENT
ASSEMBLAGE D'UN COMMUTATEUR A RHEOSTAT INCORPORE

(30) Priorität: 27.06.1990 DE 4020452; 27.02.1991 DE 4106177
(43) Veröffentlichungstag der Anmeldung: 28.04.1993
(73) Patentinhaber: Marquardt GmbH, D-78604 Rietheim-Weilheim (DE)
(72) Erfinder: ZIMMERMANN, Bernhard, D-7200 Tuttlingen (DE); NIKLEWSKI, Gerhard, D-7218 Trossingen (DE)
(74) Vertreter: Patentanwälte Eisele, Otten & Roth
(86) Internationale Anmeldenummer: DE9100529
(87) Internationale Veröffentlichungsnummer: WO9200594

(56) Entgegenhaltungen:
- EP-A- 0 110 216
- DE-A- 3 632 511
- DE-A- 3 841 794
- FR-A- 1 472 353
- GB-A- 2 205 691
- US-A- 2 902 664
- US-A- 3 909 770

## Beschreibung

Die Erfindung betrifft einen Elektrowerkzeugschalter zur Drehzahlregelung von Elektromotoren in Elektrowerkzeugen nach dem Oberbegriff des Anspruchs 1 und einen Schalter oder Stellglied, insbesondere zur Drehzahlregelung von Elektromotoren, nach dem Oberbegriff der Anspruchs 9.

### Stand der Technik:

Eine stufenlose Drehzahlregelung von Elektrowerkzeugen, wie z. B. Bohrmaschinen, geschieht mittels elektronischen Schaltern bzw. Elektronikmodulen. Die Betätigung eines Drückers bzw. eines Stellrades wirkt auf ein Stellglied, welches eine Änderung einer elektrischen Meßgröße ergibt. Als Stellglied wird im allgemeinen ein Potentiometer verwendet, welches als Teil des Schalters bzw. des Elektronikmoduls ausgebildet ist. Dabei ist der Drücker bzw. das Stellrad mit einem Potentiometer-Schleifer versehen, der auf einer zugehörigen Widerstandsbahn gleitet. Diese ist auf einer großflächigen Trägerplatine oder Leiterplatte aufgedruckt, wobei die Leiterplatte üblicherweise gleichzeitig als Träger für Leiterbahnen und sonstige elektrische Bauelemente und anderen Komponenten dient.

Bei der Herstellung von Leiterplatten werden besondere Technologien angewandt. Bedingt durch die unterschiedlichen Anforderungen gelangen verschiedene Grundmaterialien - sogenannte Hartpapiere - zum Einsatz. Dies sind beispielsweise kupferkaschiertes Hartpapier auf Phenolharzbasis auf Epoxydharzbasis oder kupferkaschierter Schichtpreßstoff aus Epoxydharzglasseidengewebe, d. h. glasfaserverstärkt. Das Basismaterial kann einseitig oder beidseitig mit einer Kupferfolie versehen sein, wobei die Kupferfolie im Siebdruckverfahren mit einem Ätzlack oder beim Fotoverfahren mit einem Fotolack an den Stellen geschützt ist, an denen die Leiterzüge und Lötaugen entstehen sollen. Das freiliegende Kupfer wird dann weggeätzt.

Soll eine derartige Leiterplatte zusätzlich mit einer Potentiometerbahn bzw. Widerstandsbahn versehen werden, so wird diese ebenfalls, z. B. in einem Siebdruckverfahren, in Pastenform auf das Basismaterial aufgebracht und eingebrannt. Während dieses Bearbeitungsvorgangs werden jedoch die bereits hergestellten Kupferleitbahnen durch Oxidation beeinflußt, so daß wiederum eine Nachbehandlung erforderlich ist. Es stellen sich insbesondere negative chemische und thermische Wechselwirkungen zwischen der geätzten Leiterplatte und der aufgebrachten Widerstandsbahn beim Einbrennprozeß ein. Dabei unterliegt der Widerstandswert der aufgebrachten Widerstandsbahn einer sehr hohen Exemplarstreuung, die durch Material und Herstellungsprozeß hervorgerufen wird. Diese Streuung kann bis zu +/- 20 % des Widerstands-Sollwerts betragen. Die zusätzliche Aufbringung einer Kohleschichtbahn als Widerstandsbahn auf eine Leiterplatte stellt auch ein zusätzliches Fertigungsrisiko bei der Herstellung des Schalter- bzw. Elektronikmoduls dar. Weiterhin ist die in bekannter Technik aufgebrachte Widerstandsbahn auf die Leiterplatte anfällig gegenüber Umwelteinflüssen, wie z.B. Feuchtigkeit, Temperatur sowie weiterhin gegenüber Ausgasung des Trägermaterials beim Einbrennprozeß der Leiterbahn, was ein Driftverhalten des elektrischen Wertes sowohl bei der Fertigung als auch während der Nutzung zur Folge hat.

Die Herstellung einer Widerstandsbahn auf die bestehende Leiterplatte eines Schalters bzw. eines Elektronikmoduls in Verbindung mit der Benutzung von Einbrennpasten (R-Paste) hat auch den Nachteil eines erhöhten Abriebs beim Betrieb, sofern nur niedrigere Einbrenntemperaturen aufgrund der verwendeten Trägermaterialien verwendet werden können.

Die Aufbringung von Widerstandsbahnen auf konventionell zu bestückenden Leiterplatten zur Herstellung eines Schalters bzw. eines Elektronikmoduls gestattet keine optimale Handhabung der Leiterplatte selbst. Insbesondere findet keine analog zu den restlichen auf der Leiterplatine angeordneten elektronischen Bauelementen sich einstellende Regelcharakteristik statt, was jedoch für eine automatische, moderne Fertigung von vollelektronischen Einheiten erforderlich wäre.

Seit einigen Jahren hat die sogenannte SMD-Technik (Surface Mounted Device) Einzug in industrielle Produkte gefunden. Insbesondere wird diese Technik für Dünn- und Dickfilmschaltungen, aber auch für die Miniaturisierung von Platinenaufbauten herangezogen. Die Grundlage für diese neue Technik bilden miniaturisierte Bauelemente (SMDs = Surface Mounted Devices), die direkt auf die Oberfläche von Leiterplatten oder Keramiksubstraten montiert werden. SMD-Chips sind insbesondere auch für die Verarbeitung mit Bestückungsautomaten und für alle Lötverfahren, so z. B. für das Tauchlöten oder Reflowlöten, geeignet. Daher können sie - nach Fixierung durch einen Klebetropfen auf der Leiterplatte - zusammen mit dieser durch das Lötbad gefahren werden. SMDs lassen sich auf der Leiterplatte einseitig, beidseitig oder in gemischter Bestückung mit herkömmlich bedrahteten Bauelementen einsetzen. Die Mischbestückung ist dann zweckmäßig, wenn die vorgesehene Schaltung allein mit SMDs nicht zu realisieren ist.

Die Hauptvorteile der SMD-Technik liegen in der Miniaturisierung, in günstigen HF-Eigenschaften, in einem sehr hohen Qualitätsstandard und in einer Kostenreduzierung sowohl bei den Bauelementen als auch bei der Leiterplatte.

Als Bauelemente sind in der SMD-Technik auch sogenannte SMD-Chip-Widerstände bekannt geworden. Diese haben, ebenso wie die weiteren SMD-Bauelemente, eine einheitliche Baugröße von 3,2 mm Länge, 1,6 mm Breite und 0,6 mm Dicke. Ein hochreines Keramikmaterial (Aluminiumoxid, Silizium) dient dabei als Grundsubstrat zum Auftrag der Widerstandsschicht, was im allgemeinen im Siebdruckverfahren geschieht. Die Zusammensetzung der Beschichtung der Widerstandsbahn wird dabei so gewählt, daß der gewünschte Widerstand annähernd erreicht wird. Durch das sogenannte Lasertrimmen kann dann der Nennwiderstand fixiert werden. Zum Schutz der Widerstandsfläche wird das Bauelement mit einer Glasur überzogen. An den Enden des Bauelements sind Endkontakte aus Metall angebracht, die mehrlagig aufgebaut sein können. Um eine zuverlässige Verbindung zwischen Endkontakten und Widerstandsschicht zu erreichen, wird eine Basismetallisierung vorgesehen.

Neben solchen SMD-Chip-Widerständen sind weiterhin als Bauelement sogenannte SMD-Keramik-Vielschicht-Chip-Kondensatoren bekannt geworden, die nach bekannten Methoden aufgebaut sind. Weiterhin sind Tantal-Chip-Kondensatoren oder Aluminium-Chip-Elektrolyt-Kondensatoren bekannt. Schließlich gibt es als SMD-Bauelement Transistoren und Dioden, die einheitlich an die Abmaße angepaßt sind.

Aus der DE 37 41 175 Al ist ein veränderbarer Widerstand bekannt geworden, der als isoliertes Bauelement ebenfalls in SMD-Technik handhabbar ist, d. h. als separates Bauelement auf eine Platine auflötbar wäre. Dieses Bauelement besteht aus einer Trägerschicht mit aufgebrachter Widerstandsbahn und eingesetztem Potentiometerschleifer. Ein derartiger veränderbarer Widerstand könnte ebenfalls auf eine Platine in SMD-Technik, insbesondere als Trimmpotentiometer, eingesetzt werden. Er hat den Vorteil, daß er unabhängig von der Platinenherstellung als separates Bauelement herstellbar ist.

### Aufgabe der Erfindung:

Der Erfindung liegt die Aufgabe zugrunde, einen Schalter, insbesondere zur Drehzahlregulierung von Elektrowerkzeugen, zu schaffen, bei welchem die geschilderten Nachteile bei der Integrierung einer Widerstandsbahn auf der Leiterplatte vermieden werden, d. h. der Herstellungsprozeß der Gesamteinheit vereinfacht und verbessert wird. Insbesondere sollen die negativen Einflüsse bei der Herstellung der unterschiedlichen Leiterplattenkomponenten vermieden werden.

Diese Aufgabe wird ausgehend von einem Schalter nach dem Oberbegriff des Anspruchs 1 durch die kennzeichnenden Merkmale des Anspruchs 1 gelöst. In den Unteransprüchen sind vorteilhafte und zweckmäßige Weiterbildungen des erfindungsgemäßen Grundgedankens wiedergegeben.

### Vorteile der Erfindung:

Der Erfindung liegt der Kerngedanke zugrunde, bei der Herstellung einer Schalterplatine bzw. eines Elektronikmoduls für einen Schalter den bisher üblichen Herstellungsprozeß für die Baueinheiten "gedruckte Leiterplatte" und "Potentiometer-Widerstandsbahn" weitestgehend zu entkoppeln. Damit kann jede Baueinheit für sich allein optimal bezüglich allen Anforderungen ausgelegt werden. Bei diesem Entkopplungsprozeß soll demnach die bislang z. B. in Pastenform auf die gedruckte Leiterplatte aufgetragene und eingebrannte Widerstandsbahn entfallen, so daß die Leiterplatte nicht durch diesen Herstellungsprozeß negativ beeinflußt wird. Die Widerstandsbahn wird vielmehr als separates, in der SMD-Technik hergestelltes Bauelement ausgebildet und verarbeitet. Durch diese Ausbildung der Widerstandsbahn als separates Bauelement ergibt sich der wesentliche Vorteil, daß sowohl die Leiterplatte als auch die Widerstandsbahn im Herstellungsprozeß grundlegend getrennt und einzeln optimiert werden können. Dabei können moderne Fertigungsverfahren, wie automatische SMD-Bestückungsanlagen und Laserabgleich, unabhängig voneinander eingesetzt werden. Eine wirtschaftliche und flexiblere Großserienfertigung ist damit gegenüber der bisherigen Methode möglich.

Ein entscheidender Vorteil der Erfindung ergibt sich auch aus der getrennten Bauweise der SMD-Widerstandsbahn und des zugehörigen Schleifers. Hierdurch kann der Widerstand als variables SMD-Bauteil in den verschiedensten Konfigurationen und mit den verschiedensten Ohm'schen Werten hergestellt werden. Dabei läßt sich die Widerstandsbahn im separaten Herstellungsprozeß äußerst exakt herstellen, so daß auf die Leiterplatte ein außerordentlich exakt definiertes Bauelement als SMD-Widerstandselement in der SMD-Technik aufgebracht werden kann. Die Schalterplatine bzw. das Elektronikmodul des Schalters kann demnach mit verschiedenen SMD-Widerstandsbahnen als SMD-Bauelement bestückt werden. Erst durch das Zusammensetzen des Schalters wird dann der mit dem Schalter-Betätigungsglied verbundene Schleifer auf die SMD-Widerstandsbahn aufgesetzt. Die SMD-Widerstandsbahn stellt demnach eine Art "Halbteil" dar, d. h. sie kann mit verschiedenen Widerständen der Schalterplatine zur Verfügung gestellt werden. Das fertige Potentiometer wird dann erst durch den Zusammenbau des Schalters selbst erzeugt, indem der separate Schleifer auf das SMD-Bauelement aufgesetzt wird.

In diesem Zusammenhang kann die in der SMD-Technik hergestellte Widerstandsbahn auch mit zusätzlichen Widerstandsbereichen versehen sein, um z. B. im Laserschnitt einen Abgleich des Widerstandswertes herbeizuführen. Diese Methode ist insbesondere durch die separate Zurverfügungstellung einer SMD-Widerstandsbahn möglich.

Weitere Einzelheiten der Erfindung sind in den Zeichnungen dargestellt und in der nachfolgenden Beschreibung unter Angabe weiterer Vorteile näher erläutert. Es zeigen
- Fig. 1a: eine schematische Darstellung eines Schalters mit SMD-Potentiometer in perspektivischer Ansicht,
- Fig. 1b: eine Detailansicht des SMD-Potentiometers nach Fig. 1a,
- Fig. 2: die Potentiometeranordnung nach Figuren 1a, 1b als SMD-Bauelement in verschiedenen Ansichten, wobei
- Fig. 2a: eine Seitenansicht,
- Fig. 2b: eine Draufsicht mit veränderter Stellung des Schleifers und
- Fig. 2c: eine perspektivische Darstellung der SMD-Widerstandsbahn ohne Schleifer zeigen und
- Fig. 3a - 3c: ein weiteres SMD-Bauelement bzw. eine SMD-Widerstandsbahn mit einem zusätzlichen Widerstandsbereich für einen Abgleich.

### Beschreibung des Ausführungsbeispiels:

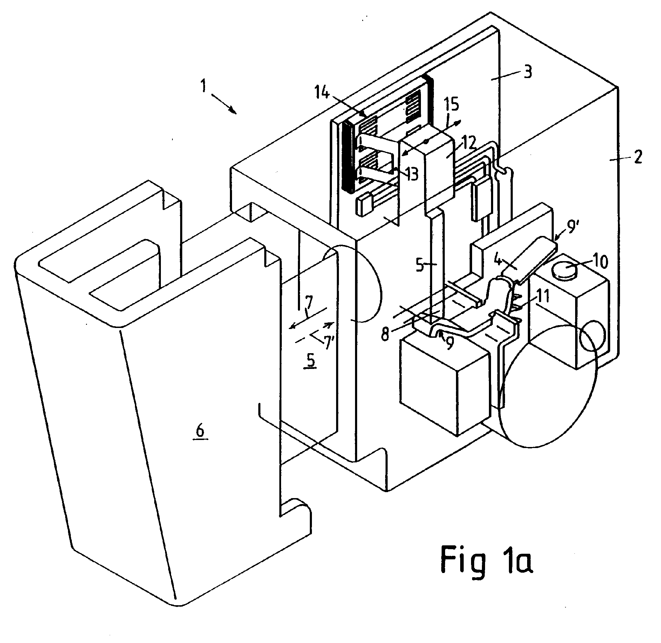

Der in Fig. 1a dargestellte Schalter 1 dient insbesondere zur Drehzahlregelung von Elektrowerkzeugen, wie beispielsweise handbetätigte Bohrmaschinen o. dgl., wobei zur Drehzahlregelung z. B. eine bekannte Schaltungsanordnung zur Phasenanschnittsteuerung verwendet wird (z. B. DE 29 14 496 Al). Hierfür besitzt der Schalter 1 ein Schaltergehäuse 2, in welchem eine als Elektronikmodul ausgebildete Leiterplatte 3 angeordnet ist. Die Leiterplatte 3 ist mit einer Bestückung von diskreten Bauelementen oder auch von SMD-Bauelementen versehen. Insbesondere die Herstellung dieser Leiterplatte 3 in SMD-Technik erlaubt eine Bestückung der SMD-Bauelemente mit einem entsprechenden Bestückungsautomaten mit hoher Taktfrequenz.

Der in Fig. 1a dargestellte Schalter weist weiterhin eine schematisch dargestellte Kontaktwippe 4 auf, die über einen Betätigungsstößel 5 eines Betätigungsgliedes 6 bzw. eines Drückers 6 in an sich bekannter Weise betätigt wird. Hierfür drückt eine nicht näher dargestellte Druckfeder den Betätigungsstößel 5 nach außen (Pfeil 7), so daß ein Schaltnocken 8 des Betätigungsstößels 5 auf das eine Ende 9 der Kontaktwippe 4 drückt und die Kontaktverbindung zwischen Kontaktbrücke 4 und Kontakt 10 öffnet. Bei manueller Betätigung des Drückers 6 wird der Betätigungsstößel 5 gegen die Druckfeder nach innen gedrückt (Pfeil 7′), so daß die Kontaktwippe 4 an ihrem Ende 9 entlastet wird. Eine Zugfeder 11 zieht das andere Ende 9′ der Kontaktwippe nach unten und schließt den elektrischen Kontakt 10.

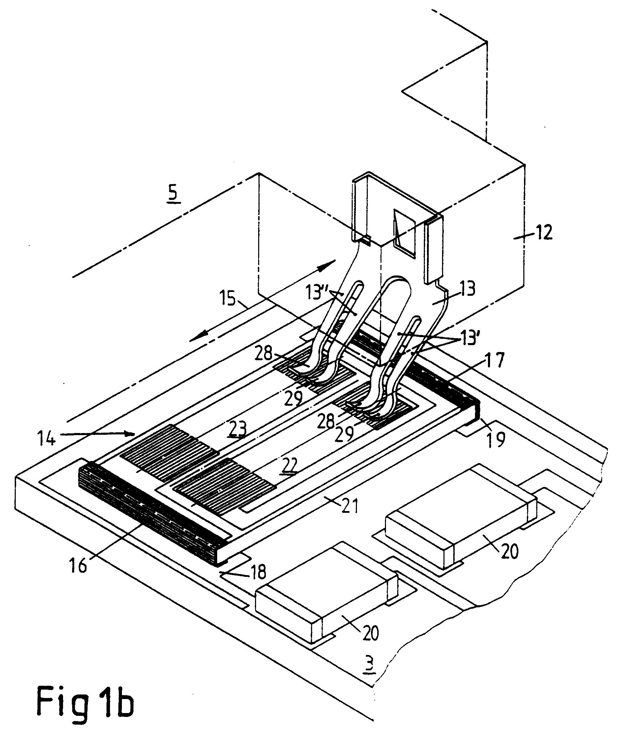

Die Betätigung des Drückers 6, d. h. dessen Linearbewegung, wird über einen Ansatz 12 mit einem hieran befestigten Schleifer 13 auf ein SMD-Widerstandselement 14 übertragen. Die Linearbewegung des Schleifers 13 am Ansatz 12 ist mit Pfeil 15 in Figuren 1a, 1b dargestellt.

Wie aus Figuren 1a, 1b weiterhin ersichtlich, ist das SMD-Widerstandselement 14 als Widerstandsbahn ausgebildet, welches als SMD-Chip-Bauteil hergestellt und in SMD-Technik auf die Leiterplatte 3, die das Elektronikmodul für den Schalter 1 darstellt, befestigt wird. Hierfür weist das Widerstandselement 14 an seinen beiden stirnseitigen Enden elektrische Endkontakte 16, 17 auf, die mit jeweils einer Leiterbahn 18, 19 der Leiterplatte 3 elektrisch verbunden sind. Dabei erfolgt die Bestückung des SMD-Widerstandselements 14 auf die Leiterplatte 3 in gleicher Weise, wie dies für bekannte SMD-Bauelemente 20 üblich ist.

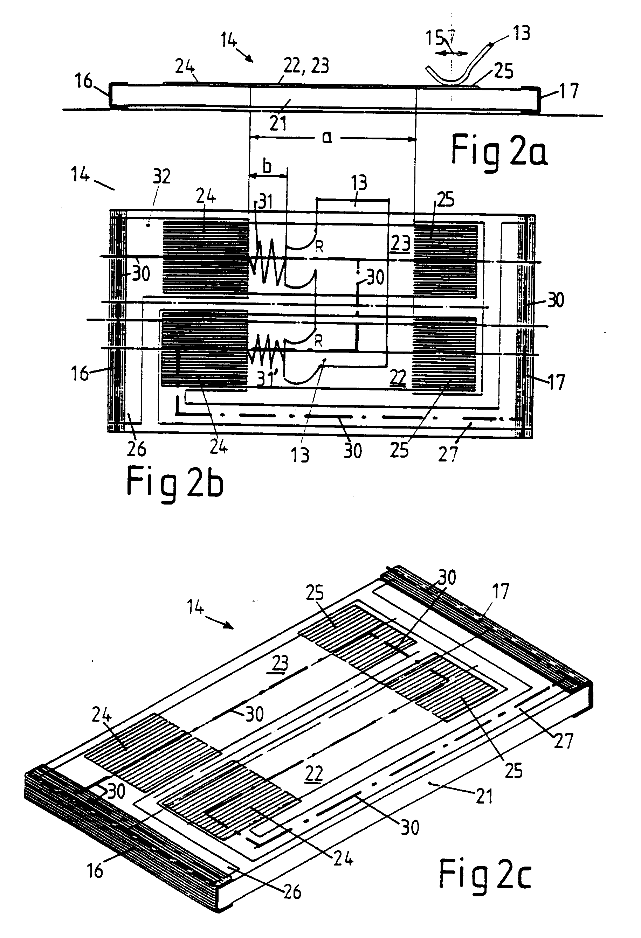

In den Figuren 1b bzw. 2a bis 2c ist das erfindungsgemäße SMD-Potentiometer, bestehend aus SMD-Widerstandselement 14 und Schleifer 13, näher angegeben. Dabei zeigt Fig. 1b das auf der Leiterplatte 3 aufgelötete Potentiometer 13, 14, während die Figuren 2a bis 2c das Potentiometer 13, 14 (Figuren 2a, 2b) bzw. das Widerstandselement 14 in Alleinstellung zeigt.

Das in SMD-Technik als SMD-Bauelement dargestellte Widerstandselement 14 besteht aus einem hochreinen Keramikmaterial, z. B. Aluminiumoxid oder Silizium, welches als Substrat für das Trägermaterial 21 dient. Im Ausführungsbeispiel sind z. B. zwei Widerstandsbahnen 22, 23 in einer Länge a vorgesehen, die im Siebdruckverfahren auf das Trägermaterial 21 aufgetragen sind. Die Länge a kann etwa 10 bis 15 mm betragen. Am Ende der Widerstandsbahnen 23, 24 befinden sich die im Widerstand gleichbleibenden Kontaktierungsabschnitte 24, 25, wobei diese Abschnitte über Zuleitungen 26, 27 mit den Endkontakten 16, 17 verbunden sind. Die Endkontakte 16, 17 dienen als Lötanschluß auf der zu bestückenden Leiterplatte 3. Die Kontaktierungsabschnitte 24, 25 am Ende der beiden Widerstandsbahnen 22, 23 sind miteinander über einen speziellen Doppelschleifer 13 in der Stellung nach Fig. 1b bzw. 2a verbunden. Der Schleifer 13 besteht demnach aus einem U-förmigen Doppelarm mit den Schenkeln 13′, 13˝, die ihrerseits wiederum in zwei Schleiferarme 28, 29 aufgetrennt sind. Am unteren Ende sind die Schleiferarme 28, 29 bogenförmig ausgebildet.

Der separate (mit dem Drücker 6 verbundene) Doppelschleifer 13 ist in Figuren lb, 2a im rechten Endanschlag eingezeichnet und gleitet gemäß der Darstellung in Fig. 2b auf den Widerstandsbahnen 22, 23 entlang (Pfeil 15) und vollzieht durch deren Überbrückung einen Widerstandsabgriff, der in Fig. 2b mit der Länge b eingezeichnet ist, d. h. die Widerstandsbahnen 22, 23 sind elektrisch in Reihe geschaltet und haben hier eine wirksame Länge von 2 x b. Um mit dem Schleifer 13 an die Widerstandsbahnen 22, 23 zu gelangen, sind diese nach oben hin zugänglich geöffnet. Die Linie 30 zeigt den Stromverlauf vom Endkontakt 16 zum Endkontakt 17. Mit Bezugszeichen 31, 31′ ist die Summe der Widerstände in Fig. 2b symbolisch dargestellt, d. h.
R (gesamt) = R (31) + R (31′).

Mit Bezugszeichen 32 ist ein Plateau dargestellt, welches als gedruckte Fläche für einen Nullabgleich dienen kann.

In Fig. 2c ist die SMD-Widerstandsbahn ohne Schleifer 13 in perspektivischer Darstellung gezeigt. Gleiche Teile sind mit gleichen Bezugszeichen versehen.

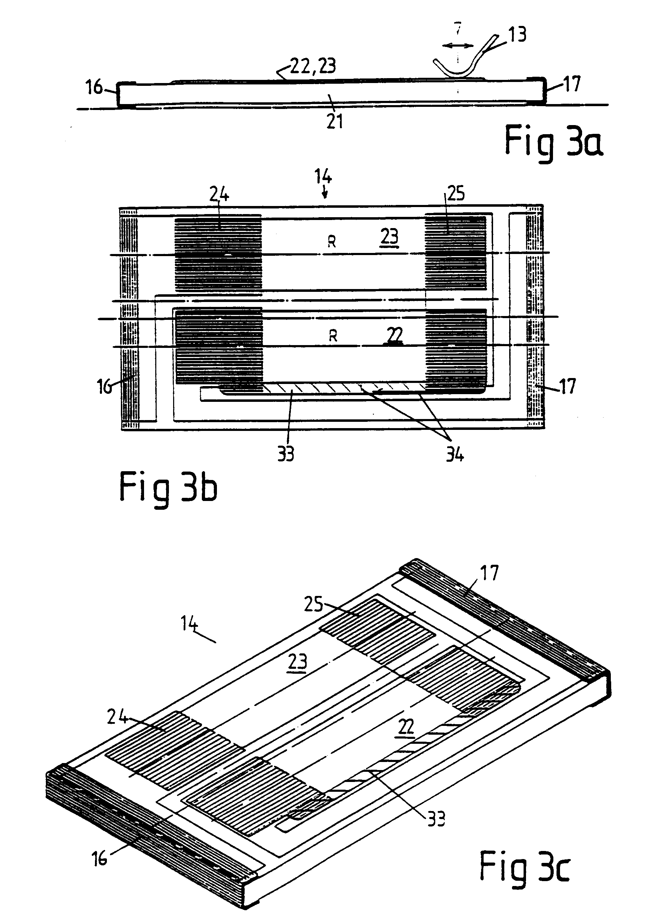

In der Darstellung nach Figuren 3a bis 3c ist eine weitere Variante gezeigt. Zusätzlich zu den eigentlichen Widerstandsbahnen 22, 23, die ebenso wie in den vorhergehenden Figuren mit einem "R" gekennzeichnet sind, ist gleichzeitig auf denselben "SMD-Chip" ein Widerstandsbereich 33 definiert, der zum elektrischen Abgleich des Potentiometers bzw. der gesamten Elektronik dient. Mit Hilfe eines symbolisch angedeuteten Laserschnittes 34 kann eine eventuell auftretende Bauelement-Toleranz ausgeglichen werden.

Im übrigen stimmt das Ausführungsbeispiel nach Fig. 3 mit demjenigen nach Figuren 1 und 2 überein. Auch hier sind die beiden Widerstandsbahnen 22, 23 auf ein Trägermaterial 21, z. B. Silizium, aufgebracht und in der an sich bekannten SMD-Technik hergestellt und verarbeitet.

Stirnseitig sind wiederum Endkontakte 16, 17 vorgesehen, die als Metallrahmen ausgebildet sind. Es können dabei ein oder, wie im Ausführungsbeispiel nach Figuren 1 bis 3, auch zwei oder mehrere Bahnen 22, 23, 33 aufgebracht sein. In Seitenansicht ist der Doppelschleifer 13 in Fig. 3a für einen Widerstandsabgriff schematisch in seiner rechten Endstellung angedeutet.

Bei der vorliegenden Erfindung kann im Gegensatz zu üblichen Widerständen in SMD-Technik der Schleifer 13 direkt auf der SMD-Widerstandsbahn 22, 23 für einen Widerstandsabgriff aufgesetzt werden, d. h. der sonst übliche Schutzüberzug entfällt in diesem Bereich.

Die in den Figuren 2 und 3 dargestellten SMD-Widerstandselemente können wahlweise in einem Schalter nach Fig. 1a auf die als Elektronikmodul ausgebildete Leiterplatte 3 aufgesetzt werden. Maßgeblich für die Erfindung ist der getrennte Aufbau zwischen SMD-Widerstandselement 14 mit zugehörigen Widerstandsbahnen 22, 23 auf der Leiterplatte 3, wodurch in Verbindung mit dem Doppelschleifer 13 ein flexibler Widerstand, d. h. ein SMD-Potentiometer, in einem Schalter zur Verfügung gestellt wird.

Selbstverständlich läßt sich das SMD-Chip-Widerstandselement in Verbindung mit dem separaten Schleifer auch als sonstiges Potentiometer-Stellglied im Zusammenhang mit elektronischen Schaltungen verwenden.

## Patentansprüche

1. Elektrowerkzeugschalter zur Drehzahlregulierung von Elektromotoren in Elektrowerkzeugen, mit einer in einem Schaltergehäuse (2) angeordneten Leiterplatte (3) zur Aufnahme elektronischer Bauelemente und einer auf der Leiterplatte (3) vorgesehenen Widerstandsbahn (14) für einen regelbaren Widerstand, auf welcher ein mit einem manuell betätigbaren Betätigungsglied (Drucker) (6) des Schalters (1) verstellbarer Schleifer (13) gleitet, dadurch gekennzeichnet, daß die Widerstandsbahn als separates SMD-Chip-Bauteil (14) (SMD = Surface Mounted Device) ausgebildet ist, welches unabhängig vom Potentiometerschleifer (13) in SMD-Technik auf die Leiterplatte (3) eines Elektronikmoduls aufsetzbar und damit unabhängig vom Schleifer (13) handhabbar ist.

2. Elektrowerkzeugschalter nach Anspruch 1, dadurch gekennzeichnet, daß das SMD-Widerstandselement (14) ein Trägersubstrat (21) aufweist, auf welchem ein oder mehrere Widerstandsbahnen (22, 23) als Kohlebahnen, vorzugsweise im Siebdruckverfahren, aufgebracht sind.

3. Elektrowerkzeugschalter nach Anspruch 2, dadurch gekennzeichnet, daß das Trägersubstrat (21) aus einem Keramik oder Epoxydharzträger besteht.

4. Elektrowerkzeugschalter nach Anspruch 2 oder 3, dadurch gekennzeichnet, daß das SMD-Widerstandselement (14) zwei parallele Widerstandsbahnen (22, 23)- aufweist, die auf dem Trägersubstrat (21) aufgebracht sind, und daß an beiden Enden des SMD-Widerstandselements (14) metallische Endkontakte (16, 17) zur Kontaktierung des SMD-Widerstandselements (14) auf der Leiterplatte (3) vorgesehen sind, die mit den Widerstandsbahnen (22, 23) verbunden sind.

5. Elektrowerkzeugschalter nach Anspruch 4, dadurch gekennzeichnet, daß der Schleifer (13) als Doppelschleifer zur Überbrückung der parallelen Widerstandsbahnen (22, 23) ausgebildet ist, wobei die Widerstandsbahnen (22,23) an einem ihrer beiden gegenüberliegenden Enden jeweils mit einem Endkontakt (16,17) verbunden und zwinchen den Endkontakten (16, 17) mit dem Doppelschleifer (13) in Reihe geschaltet sind.

6. Elektrowerkzeugschalter nach Anspruch 4 oder 5, dadurch gekennzeichnet, daß die Verbindung der Endkontakte (16, 17) mit den Widerstandsbahnen (22, 23) über Zuleitungen (26, 27) erfolgt.

7. Elektrowerkzeugschalter nach einem der vorhergehenden Ansprüche, dadurch gekennzeichnet, daß die Endbereiche (24, 25) jeder Widerstandsbahn (22, 23) mit Kontaktierungsabschnitten (24, 25) versehen sind.

8. Elektrowerkzeugschalter nach einem der vorhergehenden Ansprüche, dadurch gekennzeichnet, daß den Widerstandsbahnen (22, 23) ein zusätzlicher Widerstandsbereich zugeordnet ist, der mittels eines Laserschnitts für einen Abgleich des Widerstandswertes veränderbar ist.

9. Schalter oder Stellglied, insbesondere zur Drehzahlregelung von Elektromotoren, bestehend aus einem, durch eine Leiterplatte (3) gebildeten Elektronikmodul mit elektronischen SMD-Bauelementen (20), dadurch gekennzeichnet, daß auf die Leiterplatte (3) eine SMD-Chip-Widerstandsbahn (22, 23) als SMD-Widerstandselement (14) aufgesetzt ist, und daß ein separater Schleifer (13) vorgesehen ist, der mit der Widerstandsbahn (22, 23) in Eingriff steht und mit einem manuell betätigbaren Betätigungsglied (6) des Schalters (1) oder Stellglieds verstellbar ist.

## Revendications

1. Commutateur pour outil électrique, pour régler la vitesse de rotation de moteurs électriques dans des outils électriques, comportant une plaque conductrice (3) agencée dans un boîtier de commutateur (2), pour recevoir des éléments électroniques, et une voie résistante (14), prévue sur la plaque conductrice (3), pour une résistance réglable, sur laquelle glisse un curseur (13) pouvant être réglé par un organe d'actionnement (poussoir) (6) du commutateur (1) pouvant être actionné manuellement,
caractérisé en ce que la voie résistante est réalisée en tant que plaquette SMD séparée (14) (SMD = dispositif monté en surface), laquelle peut être mise en place, indépendamment du curseur potentiométrique (13), selon la technologie SMD, sur la plaque conductrice (3) d'un module électronique et, ainsi, peut être manipulée indépendamment du curseur (13).

2. Commutateur pour outil électrique selon la revendication 1,
caractérisé en ce que l'élément résistant SMD (14) présente un substrat de support (21), sur lequel sont disposées une ou plusieurs voies résistantes (22,23), sous forme de voies de carbone, de préférence par sérigraphie.

3. Commutateur pour outil électrique selon la revendication 2,
caractérisé en ce que le substrat de support (21) est constitué d'une céramique ou d'un support de résine époxy.

4. Commutateur pour outil électrique selon la revendication 2 ou 3,
caractérisé en ce que l'élément résistant SMD (14) présente deux voies résistantes parallèles (22,23), qui sont disposées sur le substrat de support (21), et en ce que, aux deux extrémités de l'élément résistant SMD (14), des contacts d'extrémité métalliques (16,17) pour le contact de l'élément résistant SMD (14) sur la plaque conductrice (3) sont prévus, lesquels sont reliés aux voies résistantes (22,23).

5. Commutateur pour outil électrique selon la revendication 4,
caractérisé en ce que le curseur (13) est réalisé sous forme de curseur double pour ponter les voies résistantes parallèles (22,23), les voies résistantes (22,23) étant reliées, à une de leurs deux extrémités opposées, à chaque fois, à un contact d'extrémité (16,17) et montées en série entre les contacts d'extrémité (16,17) avec le curseur double (13).

6. Commutateur pour outil électrique selon la revendication 4 ou 5,
caractérisé en ce que la liaison des contacts d'extrémité (16,17) avec les voies résistantes (22,23) est effectuée par l'intermédiaire de lignes électriques (26,27).

7. Commutateur pour outil électrique selon une des revendications précédentes,
caractérisé en ce que les zones d'extrémité (24,25) de chaque voie résistante (22,23) sont munies de segments de contact (24,25).

8. Commutateur pour outil électrique selon une des revendications précédentes,
caractérisé en ce qu'une zone résistante supplémentaire est associée aux voies résistantes (22,23), qui peut être modifiée au moyen d'une découpe au laser pour un réglage de la valeur de résistance.

9. Commutateur ou organe de réglage, en particulier pour régler la vitesse de rotation de moteurs électriques, constitué d'un module électronique formé par une plaque conductrice (3), ayant des éléments électroniques SMD (20), caractérisé en ce que, sur la plaque conductrice (3), il est prévu une voie résistante (22,23) sous forme d'élément résistant SMD (14), et en ce qu'un curseur séparé (13) est prévu, qui est en engagement avec la voie résistante (22,23) et peut être réglé par un organe d'actionnement (6), pouvant être actionné manuellement, du commutateur (1) ou de l'organe de réglage.

## Claims

1. A switch for electrically operated tools for regulating the speed of electric motors in electrically operated tools, with, disposed in a switch housing (2), a circuit board (3) for accommodating electronic components and, provided on the circuit board (3), a resistor path (14) for a regulable resistor, sliding on which there is a wiper (13) adjustable by a manually operable actuating member (push-button) (6) of the switch (1), characterised in that the resistor path is constructed as a separate SMD (surface mounted device) chip component (14) which can be mounted on the circuit board (3) of an electronic module independently of the potentiometer wiper (13) using the SMD technique, so that it can be handled independently of the wiper (13).

2. A switch for electrically operated tools, according to Claim 1, characterised in that the SMD resistance element (14) comprises a carrier substrate (21) on which are mounted one or a plurality of resistor paths (22, 23) as carbon paths, preferably by a screen printing process.

3. A switch for electrically operated tools according to Claim 2, characterised in that the carrier substrate (21) consists of a ceramic or epoxy resin carrier.

4. A switch for electrically operated tools according to Claim 2 or 3, characterised in that the SMD resistance element (14) has two parallel resistor paths (22, 23) which are mounted on the carrier substrate (21) and in that there are at both ends of the SMD resistance element (14) metallic end contacts (16, 17) for contacting the SMD resistance element (14) on the circuit board (3) which are connected to the resistor paths (22, 23).

5. A switch for electrically operated tools according to Claim 4, characterised in that the wiper (13) is constructed as a double wiper for bridging the parallel resistor paths (22, 23), the resistor paths (22, 23) being connected at one of their two opposite ends respectively to an end contact (16, 17) and are connected in series to the double wiper (13) between the end contacts (16, 17).

6. A swith for electrically operated tools according to Claim 4 or 5, characterised in that the end contacts (16, 17) are connected to the resistor paths (22, 23) by leads (26, 27).

7. A switch for electrically operated tools according to one of the preceding Claims, characterised in that the end portions (24, 25) of each resistor path (22, 23) are provided with contacting portions (24, 25).

8. A switch for electrically operated tools according to one of the preceding Claims, characterised in that there is associated with the resistor paths (22, 23) an additional resistance area which can be varied by a laser intersection for an alignment of the resistance level.

9. A switch or a positioning member, particularly for regulating the speed of electric motors, consisting of an electric module formed by a circuit board (3), with electronic SMD component elements (20), characterised in that an SMD chip resistor path (22, 23) is mounted on the circuit board (3) as an SMD resistance element (14) and in that a separate wiper (13) is provided which engages the resistor path (22, 23) and is adjusted by a manually operated actuating member (6) of the switch (1) or positioning member.
